# EUROPEAN PATENT APPLICATION

(11) **EP 1 383 006 A1**
(43) Date of publication of application: **21.01.2004**
(21) Application number: 02705182.0
(22) Date of filing: 14.03.2002
(51) Int. Cl.: G03F 7/038, H05B 33/12

(54) **NEGATIVE PHOTOSENSITIVE RESIN COMPOSITION AND DISPLAY DEVICE USING THE SAME**

(30) Priority: 19.03.2001 JP 2001078065
(71) Applicant: Clariant International Ltd., 4132 Muttenz (CH)
(72) Inventor: KOBAYASHI, Satoshi c/o Clariant(Japan)K.K., Daitocho, Ogasa-gun, Shizuoka 437-1496 (JP)
(74) Representative: Hütter, Klaus, Dr.
(86) International application number: PCT/JP2002/002416
(87) International publication number: WO 2002/075455

(57) **Abstract**

A negative working radiation sensitive resin composition comprising; an alkali-soluble novolak resin treated by fractionation and having 1,000 to 10,000 of weight average molecular weight as determined by polystyrene standard, where the portion with molecular weight of 500 or less is 5% or less in the total weight of the composition; a crosslinking agent; and a photo acid generator. This negative working radiation sensitive resin composition can be used preferably as etching resist, ion implantation resist, plating resist, LCD panel structural material such as spacer and electrode insulation material for an organic EL display because of having wide process margin, high heat resistance, high sensitivity, high resolution and good pattern shape.

## Description

### Technical Field

This invention relates to a novel negative working radiation sensitive resin composition, further in details to a negative working radiation sensitive resin composition having high sensitivity, high resolution, high heat resistance, and wide process margin on post-exposure bake (PEB), development, etc. and being preferably used for manufacturing a liquid crystal display face of a LCD (liquid crystal display) panel or a structural material of a liquid display device, further an electrode insulation material for an organic EL display etc. Besides this invention relates to a display device containing hardened substance of this negative working radiation sensitive resin composition as a structural material.

### Background Art

Upon manufacturing a liquid crystal display face of a LCD panel, various kinds of positive working or negative working radiation sensitive resin compositions (photoresists) have been being so far used as an etching, ion implantation or plating resist material etc. for forming display electrodes, wiring, thin film semiconductors, color filters, etc. Besides the hardened substance obtained by pattern wise photo-hardening of these radiation sensitive resin compositions is used for a structural material of a liquid crystal display device. The use of these radiation sensitive resin compositions is not only limited in a liquid crystal display device but also applied for a display device such as an EL display in the similar purpose. In the recent years, large-sizing of mother glass for a LCD panel preparation is being promoted and the high-degree miniaturization of patterns on a display face is also being required in the same time. On the other side, in a liquid crystal display device, integration technology (system on panel) to form a liquid crystal screen and surrounding circuits on the same substrate is being required in order to respond to the miniaturization, high density, and high driving speed of the device, multi-functionality of display and low cost requirement. Further, in order to respond to these requirements, a TFT liquid crystal panel using low temperature polysilicon in stead of amorphous silicon as a semiconductor material is being paid attention. And then in the LCD panel using this low temperature polysilicon, it is as mentioned above that preparation for large size LCD panels is also being required.

However upon adopting low temperature polysilicon for large size LCD panels, it is said that load on resist upon ion implantation is getting heavy, in other words the increase in temperature of a substrate is getting larger. In general, it is said that the temperature loaded on the resist surface upon ion implantation would be 300 °C or higher. Since the photoresists so far applied have no resistance to such temperature, the condition has to be relaxed by decreasing the ion implantation temperature. In order to further intensify the ionic condition, higher heat resistance of photoresist itself and besides almost no deformation of a pattern upon heating is being required. In such way, by increasing the heat resistance of photoresist, the ionic condition can be intensified and the realization of TFT elements with higher performance is made possible. Since the ion implantation at high energy is made possible, tact time can be shortened. Therefore it is thought that a photoresist having high heat resistance, high sensitivity, high resolution, and good pattern shape is getting more and more necessary.

However photoresist materials of cyclized polyisoprene or novolak species which is used so far for photoresist in general purposes have the upper limit of heat resistance up to about 150 ºC and when this limit temperature is exceeded, pattern lappet or line width change of pattern takes place. Therefore these photoresist materials could not be applied for the process which requires the heat resistance at high temperature. From this point of view, a trial to put photosensitivity to cyclic olefin resins which are thought to be heat resistant has been made. For example, a negative working photoresist where a polymer prepared by ring-opening-polymerization of a norbornene derivative is formulated with an aromatic bisazide compound (Japanese Laid-open Patent Publication No. Sho 60-111240), a negative working photoresist where a polymer prepared by ring-opening-polymerization of a norbornene derivative is formulated with a photopolymerization initiator, a sensitizer and a copolymerization monomer (Japanese Laid-open Patent Publication No. Sho 61-23618), etc. are being proposed. Furthermore a negative working photoresist such as novolak type thermosetting resin (Japanese Laid-open Patent Publication No. Hei 5-178951) and a composition containing a cyclic olefin resin and an aromatic bisazide compound (Japanese Laid-open Patent Publication No. Hei 07-92668) are being proposed. In any case, the heat resistance is improved, however it is not enough. Therefore further improvement is being desired.

On the other side, as a method to reduce the ratio of a low molecular weight component of a novolak resin, a fractional treatment method is a representative one. As a negative working photoresist using a novolak resin which is treated by fractionation, the technique to obtain a negative working resist having excellent dry etching resistance and resolution by adding a bisazide compound into a novolak resin with the particular weight average molecular weight and dispersity (Japanese Laid-open Patent Publication No. Sho 57-86831), a resist which is characterized in that an alkali-soluble resin is a hydrogenated phenol resin with low molecular weight dispersion (Japanese Laid-open Patent Publication No. Hei 8-44061), etc. are reported. These are not enough particularly in process dependency and further improvement is being desired. Besides in Japanese Laid-open Patent Publication No.2000-292191, a positive working photoresist using a novolak resin treated by a thin film distillation method as an alkali-soluble resin was reported, however no negative working resist is disclosed.

As described above, in the negative working photoresist so far disclosed, when the temperature over 200 °C is applied for the patterned photoresist, pattern lappet or line width change of the pattern took place because of lack of heat resistance.

Considering such situation, this invention has the purposes to offer a negative working radiation sensitive resin composition having no such problems as mentioned above, which means, it has high heat resistance, high sensitivity, and high resolution and is able to form a pattern having a good shape, besides providing with less process dependency on dimensional accuracy.

The inventors of the present invention have found that in the negative working radiation sensitive resin composition comprising an alkali-soluble novolak resin, a crosslinking agent and an acid generator, a negative working radiation sensitive resin composition having higher sensitivity and wider process margin than that so far disclosed and having particularly superior heat resistance can be obtained by using a novolak resin with the determined molecular weight distribution and have reached to the present invention.

### Disclosure of the Invention

The present invention relates to a negative working radiation sensitive resin composition comprising an alkali-soluble novolak resin, a crosslinking agent, and a photo acid generator, wherein the aforementioned alkali-soluble novolak resin is one treated by fractionation and has a weight average molecular weight of 1, 000 to 10, 000 as determined by polystyrene standards and the portion of molecular weight, below 500 including 500 in the resin is 5% or less in the total weight of the resist composition.

The present invention also relates to a display device containing the hardened substance of above described negative working radiation sensitive resin composition as a structural material.

### Detailed Description of the Invention

Herein after, the present invention will be described more in details.

An alkali-soluble novolak resin used in the negative working radiation sensitive resin composition of the present invention is obtainable by a polycondensation between one kind of phenols or a mixture thereof and aldehydes such as formalin.

As the phenols to be used here, there may be illustrated, for example, phenol, p-cresol, m-cresol, o-cresol, 2,3-dimethylphenol, 2,4-dimethylphenol, 2,5-dimethylphenol, 2,6-dimethylphenol, 3,4-dimethylphenol, 3,5-dimethylphenol, 2,3,4-trimethylphenol, 2,3,5-trimethylphenol, 3,4,5-trimethylphenol, 2,4,5-trimethylphenol, methylene-bisphenol, methylene-bis-p-cresol, resorcinol, catechol, 2-methylresorcinol, 4-methylresorcinol, o-chlorophenol, m-chlorophenol, p-chlorophenol, 2,3-dichlorophenol, m-methoxyphenol, p-methoxyphenol, p-butoxyphenol, o-ethylphenol, m-ethylphenol, p-ethylphenol, 2,3-diethylphenol, 2,5-diethylphenol, p-isopropylphenol, α-naphthol, β-naphthol, and the like. These are used singly or as a mixture of two or more thereof.

As the aldehydes besides formalin, there may be illustrated paraformaldehyde, acetaldehyde, benzaldehyde, hydroxybenzaldehyde, chloroacetaldehyde, etc. These are used singly or as a mixture of two or more thereof.

The weight average molecular weight of the alkali-soluble novolak resin used in the negative working radiation sensitive resin composition of the present invention, as determined by polystyrene standards, is preferably 1,000 to 10,000, more preferably 2,000 to 6,000, and besides the ratio by weight of the component with molecular weight of below 500 including 500 in the resin is 5% or less to the total weight of the composition, preferably 3% or less.

The alkali-soluble novolak resin having the above described molecular weight is obtained by a fractional treatment from the novolak resin synthesized by the methods so far applied. The method of fractional treatment of an alkali-soluble novolak resin may be conducted in any conventionally known method and includes as a representative method, liquid-liquid fractionation of novolak resin using two different solvents having different dissolution abilities to the component of the resin, a method of removing low-molecular-weight components by centrifugation, a fractional treatment by a thin film distillation method, etc. Among them, a thin film distillation method is preferred.

The crosslinking agent used in the negative working radiation sensitive resin composition of the present invention includes a low molecular crosslinking agent, e.g. melamine, benzoguanamine, urea or isocyanate compounds or multifunctional epoxide group-containing compounds, and a high molecular crosslinking agent, e.g. alkoxyalkylated amino resin such as alkoxyalkylated melamine resin or alkoxyalkylated urea resin as a preferable crosslinking agent.

Aforementioned melamine compounds include, for example, melamine, methoxymethylated melamine, ethoxymethylated melamine, propoxymethylated melamine, butoxymethylated melamine, hexamethylol melamine, etc. Benzoguanamine compounds include, for example, benzoguanamine, methylated benzoguanamine, etc. , urea compounds include, for example, urea, monomethylolated urea, dimethylolated urea, alkoxymethylene urea, N-alkoxymethylene urea, ethylene urea, ethylene urea carboxylic acid, tetrakis(methoxymethyl)glycol uryl, etc., and isocyanate compounds include, for example, hexamethylene diisocyanate, 1,4-cyclohexyldiisocyanate, toluene diisocyanate, bisisocyanate methylcyclohexane, bisisocyanate methylbenzene, ethylenediisocyanate, etc.

As multifunctional epoxide group-containing compounds, compounds that contain one or more of benzene ring or heterocyclic ring and also two or more of epoxy groups in a molecule are preferred. As those multifunctional epoxide group-containing compounds, for example, bisphenolacetone diglycidyl ether, phenol novolak epoxy resin, cresol novolak epoxy resin, triglycidylisocyanurate, tetraglycidyl-m-xylenediamine, tetraglycidyl-1,3-bis(aminoethyl)cyclohexane, tetraphenylglycidyl ether ethane, triphenylglycidyl ether ethane, bisphenol hexafluoroacetone diglycidyl ether, 4,4'-bis(2,3-epoxypropoxy)-octafluorobiphenyl, triglycidyl-p-aminophenol, tetraglycidyl methaxylenediamine, etc. are raised.

Further more the examples of alkoxyalkylated melamine resins or alkoxyalkylated urea resins include methoxymethylated melamine resin, ethoxymethylated melamine resin, propoxymethylated melamine resin, butoxymethylated melamine resin, methoxymethylated urea resin, ethoxymethylated urea resin, propoxymethylated urea resin, butoxymethylated urea resin, etc.

These cross-linking agents may be used singly or in the mixture of two or more thereof , and are incorporated in an amount of usually 2 to 50 parts by weight, preferably 5 to 30 parts by weight, per 100 parts by weight of the alkali-soluble resin.

As the photo acid generator which is used for the negative working radiation sensitive resin composition of the present invention, any compounds which generates acid by irradiation of radiation can be used. As those photo acid generators, there are raised photo acid generators that have been used so far as a photo acid generator for a chemically amplified resist, for example. As those photo acid generators, there are illustrated onium salts such as iodonium salts, sulfonium salts, diazonium salts, ammonium salts, pyridinium salts, etc.; halogen-containing compounds such as haloalkyl group-containing hydrocarbon compounds, haloalkyl group-containing heterocyclic compounds (halomethyltriazine derivatives etc.), etc.; diazoketone compounds such as 1,3-diketo-2-diazo compounds, diazobenzoquinone compounds, diazonaphthoquinone compounds, etc.; sulfone compounds such as β-ketosulfon, β-sulfonylsulfone, etc.; sulfonic acid compounds such as alkylsulfonic acid esters, haloalkylsulfonic acid esters, arylsulfonic acid esters, iminosulfonates, etc.; and the like.

These photo acid generators may be used singly or in the mixture of two or more thereof , and are incorporated in an amount of usually 0.1 to 10 parts by weight, preferably 0. 5 to 5.0 parts by weight, per 100 parts by weight of the alkali-soluble resin.

Further, it is preferable to incorporate a basic compound as an additive in the negative working radiation sensitive resin composition of the present invention. This basic compound functions to control diffusion, in the resist layer, of the acid generated from the acid generator upon exposure to thereby improve resolution or exposure latitude. Such basic compounds include N-alkyl substituted quaternary ammonium hydroxide, primary, secondary or tertiary aliphatic amines, aromatic amines, heterocyclic amines, nitrogen compounds containing an alkyl group, an aryl group, etc. , compounds containing an amido group or an imido group, and the like.

As the solvent for dissolving an alkali-soluble novolak resin, a crosslinking agent, a photo acid generator, etc. in the present invention, there are illustrated ethylene glycol monoalkyl ethers such as ethylene glycol monomethyl ether, ethylene glycol monoethyl ether, etc.; ethylene glycol monoalkyl ether acetates such as ethylene glycol monomethyl ether acetate, ethylene glycol monoethyl ether acetate, etc.; propylene glycol monoalkyl ethers such as propylene glycol monomethyl ether, propylene glycol monoethyl ether, etc.; propylene glycol monoalkyl ether acetates such as propylene glycol monomethyl ether acetate (PGMEA), propylene glycol monoethyl ether acetate, etc.; lactic esters such as methyl lactate, ethyl lactate, etc.; aromatic hydrocarbons such as toluene, xylene, etc.; ketones such as methyl ethyl ketone, 2-heptanone, cyclohexanone, etc.; amides such as N,N-dimethylacetamide, N-methylpyrrolidone, etc.; lactones such as y -butyrolactone etc.; and the like. These solvents may be used singly or in the mixture of two or more thereof.

In the negative working radiation sensitive resin composition of the present invention, there may be incorporated, if necessary, dyes, adhesion aids, surfactants, etc. Examples of the dyes include Methyl Violet, Crystal Violet, Malachite Green, etc., examples of the adhesion aids include hexamethyldisilazane, chloromethylsilane etc., and examples of the surfactants include nonionic surfactants such as polyglycols and the derivatives thereof, i.e., polypropylene glycol or polyoxyethylene lauryl ether, etc.; fluorine-containing surfactants such as Fluorad (trade name; product of Sumitomo 3M Co., Ltd.), Megafac (trade name; product of Dai-nippon Ink & Chemicals, Inc . ) , Surflon (trade name; product of Asahi Glass Company, Ltd.) and organosiloxane surfactants such as KP341 (trade name; product of Shin-Etsu Chemical Co., Ltd.).

The negative working radiation sensitive resin composition of the present invention can be preferably utilized for a structural material for a LCD panel such as a spacer etc. or electrode insulation materials for an organic EL display etc. So far silica or plastic particles are used as a spacer. However when a spacer enters into dots, it might cause deterioration of image etc. and therefore is not favorable. Not by spreading these particles but by putting pillars on the area without dot in the panel there is such method to form a spacer (post spacer) and the negative working radiation sensitive resin composition of the present invention can be preferably utilized as such post spacer. Further, in an organic EL display, application of RGB organic EL media for distinguishing in three color independent luminescent system or electrode formation are conducted and in such case the negative working radiation sensitive resin composition of the present invention having the heat resistance can be effectively utilized as cathode insulation materials.

### Best mode for practicing the Invention

Hereafter the present invention will be described concretely with examples, however the present invention should not be limited in these examples.

### Synthesis Example 1

60 g of m-cresol, 45 g of p-cresol, 16 g of 2,5-xylenol, 90g of 37 weight-% formalin aqueous solution and 1 g of oxalic acid are fed into 1 liter-separable flask equipped with agitator, condenser and thermometer, and under agitating, the mixture thereof is reacted for 5 hours at 100 °C. After that, while heating up to 180 ° C in 1 hour, water and unreacted monomer are removed by distillation. Further while heating up to 200 ° C, the pressure is reduced down to 100 mmHg to remove water, unreacted monomer, formaldehyde and oxalic acid as much as possible and the temperature is cooled down to room temperature to recover a novolak resin. The weight average molecular weight (Mw) of the obtained novolak resin by GPC (gel permeation chromatography) as determined by polystyrene standards was 7,200. The ratio of the portion with molecular weight of 500 or below was 10.3% to the total weight of novolak resin.

### Synthesis Example 2

Novolak resin was obtained in the same manner as Synthesis Example 1 except for using m-cresol 70g and p-cresol 60g as reactive monomers. 400 g of the novolak resin thus obtained was dissolved in 600 g of PGMEA, and then pure water was added into this solution followed by agitation for 15 minutes. After leaving the solution for 30 minutes at around room temperature, PGMEA resin solution layer was taken out and was fed into the thin film distillation equipment (manufactured by Hitachi Ltd. ) . While PGMEA solution was dropped continuously, novolak resin B was recovered by thin film distillation under vacuum of 15 mmHg at 260 °C. Mw of resin B was 4,800. The ratio of the portion with molecular weight of 500 or below was 2.11% to the total weight of novolak resin.

### Example 1

(1) Alkali-soluble novolak resin B obtained in Synthesis Example 2 100 parts by weight
(2) Hexamethoxymethylated melamine resin 10 parts by weight
(3) 2(4'-methoxynaphthyl)-4,6-tris(trichloromethyl)triazine 1.5 parts by weight and
(4) Tetrabutylammonium hydroxide 0.5 parts by weight
   were dissolved in propylene glycol monomethyl acetate(PGMEA), filtrated with 0.2 µm membrane filter made from Teflon and the negative working radiation sensitive resin composition was prepared.

This composition was spin-coated on a 4-inch silicon wafer, and baked on a hot plate at 100 ° C for 90 seconds to form a 1.5-pm thick resist layer. This resist layer was exposed by a g-line stepper made by GCA Co. (DSW6400, NA=0.42), post exposure bake (PEB) is made at 120 ° C for 90 seconds and developed in a 2.38 weight-% aqueous solution of tetramethylammonium hydroxide for 60 seconds to form the resist pattern. By observing the obtained resist pattern through the scanning electronic microscope (SEM), the optimum exposure energy (Eo) of 3-µm pattern was obtained. The result is shown in Table-1.

### Comparative Example 1

The preparation of a negative working radiation sensitive resin composition and the formation of a resist pattern thereof were conducted in the same manner as Example-1 except for using the alkali-soluble novolak resin A obtained in synthesis Example-1 in stead of alkali-soluble novolak resin B. After that as in Example-1, the optimum exposure energy (Eo) of 3 pm pattern was obtained. The result is shown in Table-1.

**Table-1**

| Sensitivity | | |
|---|---|---|
| | Example 1 (Resin B) | Comparative Example 1 (Resin A) |
| Eo (mJ/cm²) | 150 | 200 |

From Table-1, it proves that the negative working radiation sensitive resin composition of the present invention has 25% higher sensitivity.

### Example 2

Except setting PEB temperature at 120 ° C and 140 ° C, the same manner as Example-1 was taken to form a resist pattern. The line widths of resist pattern formed at each temperature were observed by SEM, and PEB temperature dependency of the radiation sensitive resin composition was obtained from the obtained values according to the formula, (line width at PEB temperature, 140 °C - line width at PEB temperature, 120 °C). The results are shown in Table-2.

### Comparative Example 2

The PEB temperature dependency of the radiation sensitive resin composition was obtained by the same manner as Example-2 except for using the negative working radiation sensitive resin composition utilized in Comparative Example-1 as a negative working radiation sensitive resin composition. The result is shown in table-2.

**Table-2**

| PRR temperature Dependency | | |
|---|---|---|
| | Example 2 (Resin B) | Comparative Example 2 (Resin A) |
| Δ (line width at PEB temp. 140 °C - line width at PEB temp. 120 °C) (µm) | 0.8 | 1.8 |

As shown in Table-2, the deviation of line width according to PEB temperature dependency in the negative working radiation sensitive resin composition of the present invention is less than half compared with the negative working radiation sensitive resin composition so far disclosed. By this issue the process margin in the negative working radiation sensitive resin composition of the present invention is proved to be wide.

### Example 3

The same manner was taken as Example-1 except setting PEB temperature at 130 °C and the resist patterns were formed. The formed patterns were heat-treated at 100, 130, 140, 200 and 300 °C for 3 minutes, the pattern form of 3 µm line and the bottom line width thereof were observed by SEM. The results are shown in Table-3.

### Comparative Example 3

Except using the negative working radiation sensitive resin composition utilized in Comparative Example-1 as a negative working radiation sensitive resin composition, the same manner was taken as Example-3 to get resist patterns. The formed patterns were heat-treated at 100, 130, 140, 200 and 300 °C for 3 minutes, the pattern form of 3 µm line and the bottom line width thereof were observed by SEM. The results are shown in Table-3.

**Table-3**

| Pattern form and line width after heat treatment | | | | | |
|---|---|---|---|---|---|
| Heat temperature | 100 °C | 130 °C | 140 °C | 200 °C | 300 °C |
| Example 3 | 3.0 µm | 3.0 µm | 3.0 µm | 3.2 µm | 3.3 µm |
| Comparative Example 3 | 3.0 µm | 3.9 µm rounded form form pattern | 4.2 µm pattern lappet often observed | Pattern and pattern are put together | - |

As seen in Table-3, no big change was observed with the line-pattern-form even at 300 °C in the negative working radiation sensitive resin composition of the present invention. On the other hand, the negative working radiation sensitive resin composition so far disclosed began to deform line pattern form at 130 °C, at 200°C one pattern and another pattern was put together and line width inspection was not made.

### Advantages of the Invention

As mentioned above closely, by this invention a pattern having excellent heat resistance, high sensitivity, high resolution, and good shape can be formed, besides the negative working radiation sensitive resin composition having less process dependency of dimensional accuracy can be obtained. The negative working radiation sensitive resin composition of the present invention can be further applied usefully not only for etching resist, ion implantation resist or plating resist upon display device manufacturing, but also preferably be utilized for a LCD panel structural material such as a spacer and an electrode insulation material for an organic EL display etc.

### Industrial Applicability

The present invention is preferably used for a manufacture of liquid crystal display face of LCD (liquid crystal display) panel or a structural material of liquid display device, further an electrode insulation material for an organic EL display etc.

## Claims

1. A negative working radiation sensitive resin composition comprising an alkali-soluble novolak resin, a cross-linking agent, and a photo acid generator, wherein said alkali-soluble novolak resin is one treated by fractionation and has a weight average molecular weight of 1,000 to 10,000 as determined by polystyrene standards and the ratio by weight of the component with molecular weight of below 500 including 500 in the resin is 5 % or less in the total weight of the resist composition.

2. A display device containing the hardened substance of the negative working radiation sensitive resin composition according to claim 1 as a structural material.
